# DEMANDE DE BREVET EUROPEEN

(11) **EP 3 001 448 A1**
(43) Date de publication de la demande: **30.03.2016**
(21) Numéro de dépôt: 15184348.9
(22) Date de dépôt: 08.09.2015
(51) Int. Cl.: H01L 21/265, H01L 21/324

(54) **PROCÉDÉ DE DOPAGE D'UN SEMI-CONDUCTEUR À BASE DE GAN**

(30) Priorité: 26.09.2014 FR 1459130
(71) Demandeur: Commissariat à l'Energie Atomique et aux Energies Alternatives, 75015 Paris (FR)
(72) Inventeur: Agraffeil, Claire, 38000 Grenoble (FR)
(74) Mandataire: Talbot, Alexandre

(57) **Abrégé**

Le procédé de dopage d'un semi-conducteur à base de GaN pour fabriquer une jonction p-n comporte une première étape consistant à prévoir un substrat (1) comprenant une couche en matériau semi-conducteur (1 b) à base de GaN recouvert par un masque (3) à base de silicium. Le procédé comporte une deuxième étape d'implantation d'impuretés (2) dans le masque (3) de manière à transférer des impuretés dopantes supplémentaires (4) de type Si par diffusion depuis le masque (3) vers la couche en matériau semi-conducteur (1 b) pour former une zone de type n adjacente à une zone de type p. On réalise ensuite un traitement thermique configuré pour activer les impuretés dopantes (2) et les impuretés dopantes supplémentaires (4).

## Description

### Domaine technique de l'invention

L'invention est relative à un procédé d'implantation ionique et d'activation d'impuretés dopantes dans un semi-conducteur à base de GaN.

### État de la technique

L'implantation ionique est couramment utilisée pour doper des semi-conducteurs. Pour fabriquer des jonctions p-n, on utilise généralement des masques afin de sélectionner les zones du semi-conducteur qui doivent être implantées et les zones à protéger. On réalise ensuite l'étape d'implantation, en utilisant des ions généralement produits à partir d'une source gazeuse ou solide (source utilisée pour le Mg par exemple), qui impactent le semi-conducteur après avoir été accélérés à une énergie comprise par exemple entre 10 et 500 keV.

La nature des ions implantés est choisie en fonction du type de dopage que l'on souhaite obtenir. Les ions Mg⁺ sont par exemple utilisés pour réaliser un dopage p (excès de trous) dans des semi-conducteurs à base de GaN, tandis que les ions Si⁺ sont souvent employés pour réaliser un dopage n (excès d'électrons) du même type de semi-conducteur. Le semi-conducteur subit ensuite un traitement thermique afin d'activer plus ou moins efficacement les impuretés dopantes.

Le document « Implanted p-n junctions in GaN » (X.A. Cao et al., Solid-state Electronics, 43 (1999) 1235-1238) décrit une méthode d'implantation d'ions Si⁺ dans un semi-conducteur de type GaN dopé par des ions Mg⁺, afin d'obtenir un semi-conducteur dopé n⁺/p. Ici les ions Si⁺ sont implantés dans des zones sélectionnées au moyen d'un masque déposé sur le semi-conducteur. Le masque est enlevé après implantation, puis une couche d'AIN est déposée par pulvérisation cathodique sur le semi-conducteur afin de protéger ce dernier lors du traitement thermique d'activation des dopants.

Le document « Experimental and numerical investigation of the electrical characteristics of vertical n-p junction diodes created by Si implantation into p-GaN » (A. Baharin, Institute of Electrical and Electronics Engineers, 978-1-4244-2717-8/08, (2008)) décrit une méthode de fabrication de jonctions p-n verticales à partir de semi-conducteurs de type GaN dopés p/p⁺ au moyen d'ions Mg⁺. Ici, des ions Si⁺ sont implantés au moyen de faisceaux d'ions de différentes énergies, pour maîtriser la profondeur d'implantation dans le semi-conducteur.

### Objet de l'invention

Un objet de l'invention est de prévoir une alternative aux procédés de l'art antérieur afin de doper un semi-conducteur, notamment dans le but de fabriquer des jonctions p-n.

On tend à résoudre ce problème au moyen d'un procédé qui comporte les étapes suivantes :
- prévoir un substrat comprenant une couche en matériau semi conducteur à base de GaN recouvert par un masque à base de silicium,
- implanter des impuretés dans le masque de manière à transférer des impuretés dopantes de type Si par diffusion depuis le masque vers la couche en matériau semi-conducteur à base de GaN, pour former une zone de type n adjacente à une zone de type p,
- réaliser un traitement thermique configuré pour activer les impuretés dopantes et les impuretés dopantes supplémentaires.

Selon un aspect de l'invention, le masque peut couvrir partiellement le substrat de manière à définir une zone recouverte par le masque et une zone découverte.

L'implantation peut être réalisée avec des dopants de type p, et leur profondeur d'implantation moyenne peut être située dans le masque. Elle peut être disposée à une distance au moins égale à 300nm de l'interface de sorte à incorporer des impuretés dopantes supplémentaires dans la couche en matériau semi-conducteur.

Le procédé peut également comprendre une étape de dépôt d'une couche de protection réalisée avant l'étape de traitement thermique. Le matériau de la couche de protection peut être choisi parmi l'oxyde de silicium, ou le nitrure de silicium du type SiₓN_{y}, le silicium amorphe, et les composés du type HfSiₓO_{y}, et préférentiellement parmi l'oxyde d'aluminium et le nitrure d'aluminium.

Le dépôt de la couche de protection est réalisé avant l'étape de traitement thermique, et peut par exemple être effectué après l'étape d'implantation des impuretés dopantes et des impuretés dopantes supplémentaires, directement sur le masque, ou après retrait de ce dernier. De manière alternative, il est envisageable de déposer la couche de protection avant l'implantation des impuretés dopantes dans le cas où la couche de protection n'est pas à base de silicium. Après le traitement thermique, la couche de protection peut avantageusement être retirée.

De manière préférée, l'étape d'implantation peut être réalisée à une température comprise entre 15 et 700°C, de préférence entre 450 et 600°C.

Par ailleurs, l'étape de traitement thermique peut avantageusement comprendre une combinaison d'au moins deux recuits de durées et de températures différentes. Au moins l'un des recuits peut en outre être réalisé à une température supérieure à 1000°C.

En ce qui concerne le masque, celui-ci peut avantageusement avoir une épaisseur comprise entre 2 et 400 nm. L'épaisseur de la couche en matériau semi-conducteur peut quant à elle être comprise entre 5 nm et 10 *µ*m, préférentiellement entre 500nm et 10*µ*m, idéalement égale à 1*µ*m.

### Description sommaire des dessins

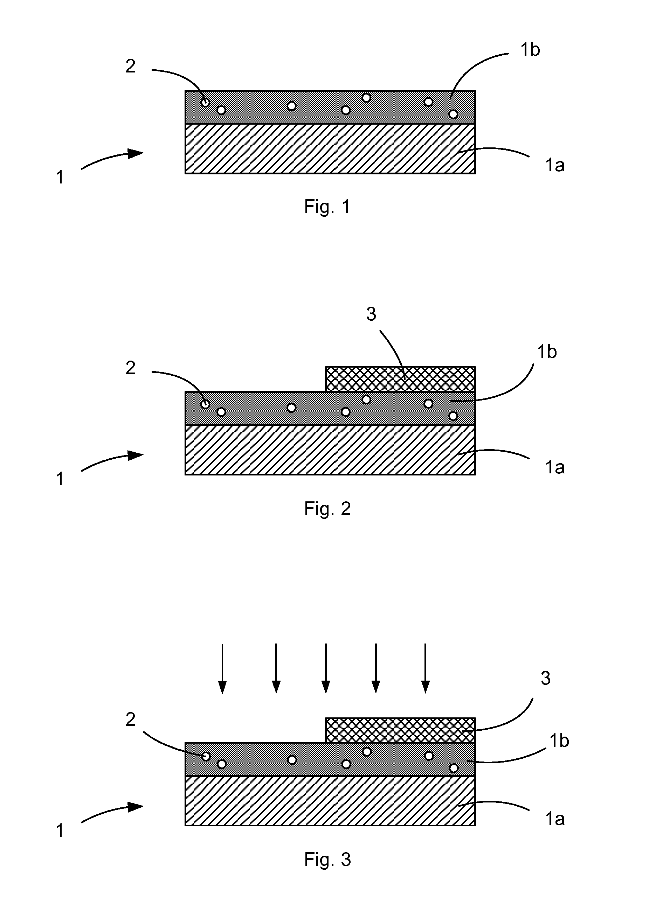

D'autres avantages et caractéristiques ressortiront plus clairement de la description qui va suivre de modes particuliers de réalisation de l'invention donnés à titre d'exemples non limitatifs et représentés aux dessins annexés, dans lesquels les figures 1 à 10 illustrent de façon schématique un mode de mise en oeuvre du procédé de dopage d'un semi-conducteur à base de GaN.

### Description détaillée

Selon un premier mode de mise en oeuvre du procédé de dopage représenté sur les figures 1 à 10, il faut tout d'abord prévoir un substrat 1 tel que celui représenté à la figure 1. Celui-ci comporte un support 1a par exemple en silicium ou en sapphire, Al₂O₃, SiC, et une couche en matériau semi-conducteur 1b à base de GaN. En alternative, le substrat 1 peut être en GaN massif.

Lorsque le substrat 1 est un bloc de GaN massif, il est possible de recouvrir la face arrière de couches de protection avantageusement identiques à celles déposées sur le substrat 1 en face avant, et qui vont être décrites ci-après. La face avant du substrat 1 est définie ici comme la face impactée par le faisceau d'impuretés dopantes, et la face arrière comme la face opposée à la face avant.

La réalisation du substrat 1 comprend avantageusement une première étape de nettoyage du support 1a, comme par exemple un nettoyage de type RCA si le support 1a est en silicium. La couche en matériau semi-conducteur 1b est ensuite fabriquée par croissance épitaxiale directement sur le support 1a. Le choix du matériau du support 1a est choisi avantageusement pour avoir des paramètres de maille similaires à ceux de la couche en matériau semi-conducteur 1 b afin que cette dernière croisse de manière cohérente.

Pour améliorer la qualité de la couche en matériau semi-conducteur 1b, une couche intermédiaire à base d'AlGaN d'au moins 1 *µ*m d'épaisseur peut éventuellement être déposée sur le support 1a avant la croissance épitaxiale de la couche 1 b (mode de réalisation non représenté). Par exemple, pour un support 1a en saphhire, la couche en matériau semi-conducteur 1b à base de GaN peut être directement déposée sur le support 1a si celui-ci est réalisé en sapphire. En revanche, s'il est réalisé en silicium, il est judicieux de déposer une couche tampon à base d'AlGaN.

Lorsque la réalisation de la couche en matériau semi-conducteur 1 b est terminée, celle-ci peut avantageusement avoir une épaisseur comprise entre 100 nm et 10 µm, préférentiellement entre 5nm et 10*µ*m, idéalement égale à 1*µ*m.

Selon un mode de réalisation avantageux, le matériau semi-conducteur 1 b à base de GaN n'est pas dopé initialement ou n'est pas intentionnellement dopé initialement. Cela permet de réaliser simultanément un dopage p et n lors de l'étape d'implantation ionique, comme on le verra plus loin et de former une couche 1b apte des former des circuits complémentaires avec des dispositifs utilisant un excès d'électrons et des dispositifs utilisant un excès de trous.

De manière alternative, il est possible d'utiliser une couche en matériau semi-conducteur 1b dopée p. Dans ce mode de mise en oeuvre, les impuretés dopantes 2 peuvent par exemple être des ions Mg+, introduits directement lors de la croissance épitaxiale (cf. figure 1).

Dans la deuxième étape du mode de mise en oeuvre, on réalise un masque 3 configuré pour recouvrir en totalité ou en partie la surface de la couche en matériau semi-conducteur 1 b. Cette étape du procédé est représentée à la figure 2. Comme illustré, le masque 3 peut couvrir partiellement le substrat 1 de façon à définir une zone recouverte et une zone découverte. Ce masque 3 peut par exemple être réalisé par photolithographie ou lithographie électronique. Son épaisseur est avantageusement comprise entre 2 et 400 nm.

Le matériau du masque 3 est à base de silicium préférentiellement, d'oxyde de silicium et/ou de nitrure de silicium, de silicium amorphe, ou de HfSiO₂. Il comporte donc des atomes de Si capables de diffuser dans le substrat 1 lorsqu'on leur apporte l'énergie nécessaire. Cette propriété permet d'implanter des atomes de Si dans le matériau semi-conducteur 1b et donc de réaliser un dopage local n.

Dans une troisième étape du mode de mise en oeuvre, on réalise une implantation de dopants 2 appliquée sur le masque 3 et sur la zone découverte du substrat 1 (cf. figure 3). Les dopants 2 peuvent être de type p, par exemple des d'ions Mg⁺, de type n comme par exemple des ions Si⁺, ou des dopants non électriquement actifs tels que des ions N⁺. La présence du masque 3 permet de ne pas dégrader la couche en matériau semi-conducteur 1 b lors de l'implantation des dopants 2.

De manière classique, les conditions d'implantation sont imposées d'une part par les performances techniques des équipements d'implantation, et d'autre part par la concentration et la localisation des impuretés dopantes 2 que l'on souhaite implanter dans la couche en matériau semi-conducteur 1 b.

Par exemple, pour un faisceau d'ions Mg⁺ ayant une fluence de 2.10¹⁵ atomes/cm² et une énergie de 200keV, les impuretés dopantes 2 peuvent être implantées dans une couche de GaN jusqu'à une profondeur de l'ordre de 400 nm avec un pic de concentration estimé à 160-180 nm. Cette profondeur est également appelée profondeur d'implantation moyenne ou Rp.

L'énergie d'implantation des dopants 2 peut être choisie pour que, dans les zones recouvertes par le masque 3, la profondeur d'implantation moyenne Rp soit située : (i) dans le masque 3 à proximité de l'interface avec la couche en matériau semi-conducteur 1b, ou (ii) dans la couche en matériau semi-conducteur 1b à proximité de l'interface avec le masque 3, ou (iii) en profondeur dans la couche en matériau semi-conducteur 1 b.

Quelle que soit l'énergie d'implantation choisie, celle-ci est suffisante pour que les dopants 2 implantés apportent l'énergie nécessaire aux atomes de Si présents dans le masque 3 pour diffuser dans la couche en matériau semi-conducteur 1 b.

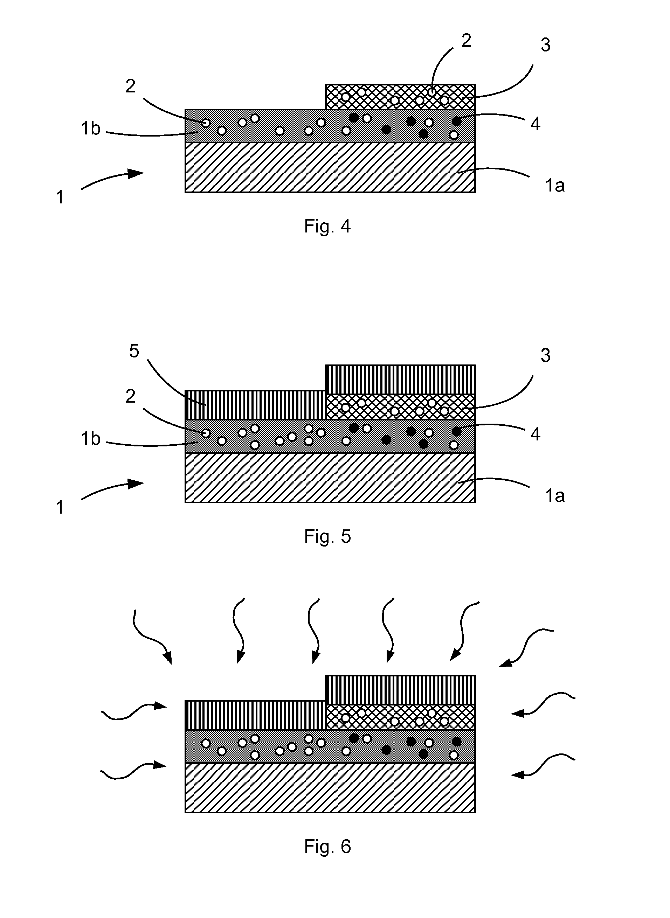

Lorsque les dopants 2 sont de type p, les zones qui ne sont pas recouvertes par le masque 3 sont directement dopées p, tandis que les dans les zones recouvertes du masque, les dopants de type p apportent l'énergie nécessaire aux atomes de Si pour diffuser. A l'issue de l'implantation ionique, la couche en matériau semi-conducteur 1b comprend des zones découvertes dotées d'impuretés dopantes 2 de type p, et des zones recouvertes dotées à la fois d'impuretés dopantes 2 de type p et d'impuretés dopantes supplémentaires 4 de type n, le dopage résiduel dans cette zone étant au final un dopage de type n (cf. figure 4).

Dans le cas de dopants 2 de type p, il peut être avantageux de choisir l'énergie d'implantation de sorte que la profondeur d'implantation moyenne soit située à l'interface entre le masque 3 et la couche en matériau semi-conducteur 1 b, ou alors à proximité de cette interface, soit dans le masque 3, soit dans la couche en matériau semi-conducteur 1 b. Après implantation, les impuretés dopantes 2 de type p et les impuretés dopantes supplémentaires 4 de type n sont alors situées dans la zone dite active du semi-conducteur 1b, c'est-à-dire la profondeur utilisée par exemple pour réaliser des jonctions ou des transistors. La zone active du semi-conducteur 1b s'étend par exemple jusqu'à 100 ou 300 nm de profondeur.

Effectuer une implantation de Si à travers le masque 3 présente l'intérêt de moins dégrader la surface de la couche en matériau semi-conducteur 1b en comparaison avec une implantation conventionnelle de Si.

Lorsque le maximum d'implantation est situé dans le masque 3 ou à l'interface entre le masque 3 et la couche semi-conductrice 1b, l'énergie apportée par les dopants 2 est suffisante pour permettre l'incorporation des atomes de Si du masque 3 jusqu'à la zone active du matériau semi-conducteur 1b. Lorsque le maximum d'implantation est situé en profondeur dans la couche semi-conductrice 1b, l'énergie apportée par les dopants de type n permettent aux atomes de Si de diffuser dans la couche 1b dans une zone plus profonde.

Réaliser une implantation de dopants non électriquement actifs peut être utile pour fabriquer une couche en matériau semi-conducteur 1 b qui soit dopée n dans les zones du semi-conducteur 1 b recouvertes par le masque 3, et non dopée ailleurs. Comme pour les implantations de type n ou de type p, l'énergie d'implantation est choisie de sorte à permettre la diffusion d'atomes de Si plus ou moins en profondeur dans la matrice semi-conductrice 1b. L'utilisation des dopants non électriquement actifs peut donner lieu à la réparation de lacunes qui sont soit créées par la diffusion des atomes de Si, soit déjà présentes dans la couche en matériau semi-conducteur 1 b.

Selon un aspect de l'invention, il peut être avantageux de contrôler la température à laquelle l'implantation ionique est réalisée. De manière préférée, cette dernière peut être exécutée à une température comprise dans une plage allant de 15°C à 700°C, avantageusement entre 200°C et 600°C, et de manière préférée entre 450°C et 600°C. Pour cela, on peut avantageusement utiliser un système permettant de chauffer la face arrière du support 1a, par exemple de type module à effet Peltier.

Le fait de réaliser un chauffage du substrat lors de l'étape d'implantation ionique permet à la fois une meilleure diffusion des dopants dans la couche en matériau semi-conducteur 1 b, et une meilleure diffusion des atomes de Si depuis le masque 3 vers la couche en matériau semi-conducteur 1 b.

Selon un mode de mise en oeuvre particulier du procédé (non représenté), le masque 3 peut être retiré après l'étape d'implantation ionique, avant de réaliser un traitement thermique du substrat 1. Le retrait peut par exemple être réalisé par gravure humide au moyen d'acide fluorhydrique (HF) si le masque est en SiO₂ ou d'acide phosphorique (H₃PO₄) si le masque est en SiNₓ ou AlN.

Avantageusement, pour activer les impuretés dopantes 2 et les impuretés dopantes supplémentaires 4, le substrat 1 peut être recuit à une température élevée, par exemple supérieure à 1000°C. Or, au-delà d'une température de l'ordre de 850°C, la couche en matériau semi-conducteur 1 b à base de GaN est fortement dégradée et une partie de l'azote s'évapore.

Il est donc avantageux de réaliser une étape de dépôt d'une couche de protection 5 après l'étape d'implantation des impuretés dopantes 2 et des impuretés dopantes supplémentaires 4, et avant de réaliser le traitement thermique. La couche de protection 5 a pour rôle de limiter fortement la dégradation de la surface de la couche semi-conductrice 1 b. Cette étape du procédé est représentée à la figure 5.

Le matériau de la couche de protection 5 peut être choisi parmi l'oxyde d'aluminium, le nitrure d'aluminium, le nitrure de silicium du type SiₓN_{y} ou l'oxyde de silicium, ou les composés du type HfSiₓO_{y}. De préférence, le matériau de la couche de protection 5 en nitrure d'aluminium.

Le dépôt peut par exemple être un dépôt chimique en phase vapeur aux organométalliques (« Metalorganic Chemical Vapor Deposition » ou « MOCVD » en anglais) réalisé dans un équipement identique à celui ayant servi pour la croissance épitaxiale de la couche en matériau semi-conducteur 1b. Le dépôt peut également être réalisé par un dépôt chimique en phase vapeur à basse pression (« Low Pressure Chemical Vapor Deposition » ou « LPCVD » en anglais).

Déposer une couche de protection 5 en nitrure d'aluminium AIN peut être judicieux car les paramètres de maille de ce matériau sont très proches de ceux du matériau semi-conducteur à base de nitrure de gallium, ce qui permet d'augmenter l'adhérence de la couche de protection 5 sur le substrat 1. Il est également possible de remplacer l'AlN par de l'AlGaN, ou par un empilement de couches d'AIN et d'AlGaN. Dans ce cas, la couche d'AlGaN peut comporter jusqu'à 50% de Ga, avantageusement jusqu'à 20% de Ga, et préférentiellement moins de 5% de Ga.

Selon un mode de mise en oeuvre préféré, la couche de protection 5 peut avoir une épaisseur comprise entre 1 et 200 nm, et plus précisément entre 1 et 100 nm. Cette épaisseur est suffisante pour créer une barrière efficace afin empêcher l'évaporation des molécules d'azote de la couche en matériau semi-conducteur 1 b lors du traitement thermique.

L'étape de traitement thermique illustrée schématiquement à la figure 6 peut comprendre des recuits rapides (« Rapid Thermal Annealing » ou « RTA » et « Rapid Thermal Processing » ou « RTP » en anglais) pour que le taux d'activation des impuretés dopantes 2 et des impuretés dopantes supplémentaires 4 soit élevé sans que la surface de la couche semi-conductrice 1 b soit endommagée.

Des recuits standards (« Furnace Annealing » en anglais) peuvent également être réalisés pour permettre une diffusion efficace des impuretés dopantes 2 et des impuretés dopantes supplémentaires 4 dans la couche semi-conductrice 1 b en position substitutionnelle.

Lors de l'étape de traitement thermique, il est donc possible de réaliser un recuit standard, un recuit rapide, ou toute combinaison de recuits rapides et standards selon le résultat que l'on souhaite obtenir. Au moins l'un des recuits peut avantageusement être réalisé à une température supérieure à 1000°C pour obtenir un taux d'activation élevé des impuretés dopantes 2 et des impuretés dopantes supplémentaires 4.

A titre illustratif, un recuit standard à une température comprise entre 850 et 1250°C peut être réalisé pendant une durée allant de quelques minutes à quelques heures. Un recuit rapide peut également être effectué dans une gamme de température allant de 850 à 1250°C, voire même allant jusqu'à 1600°C si le support 1a est en sapphire. Dans ce cas, la durée du recuit rapide est comprise entre quelques secondes et quelques minutes. Avantageusement, le ou les recuits peuvent être réalisés sous une atmosphère contrôlée contenant un gaz choisi avantageusement parmi N₂, Ar, He, NF₃, O₂, ou un mélange de N₂ / O₂, N₂ / H₂, Ar / H₂.

Les inventeurs ont observé que le traitement thermique permet d'augmenter la diffusion des dopants de type Si en direction de la couche en matériau semi-conducteur 1b. Par exemple, pour un recuit effectué à 1100°C, la concentration en impuretés dopantes 4 de type n est d'autant plus élevée que la durée du traitement thermique est longue.

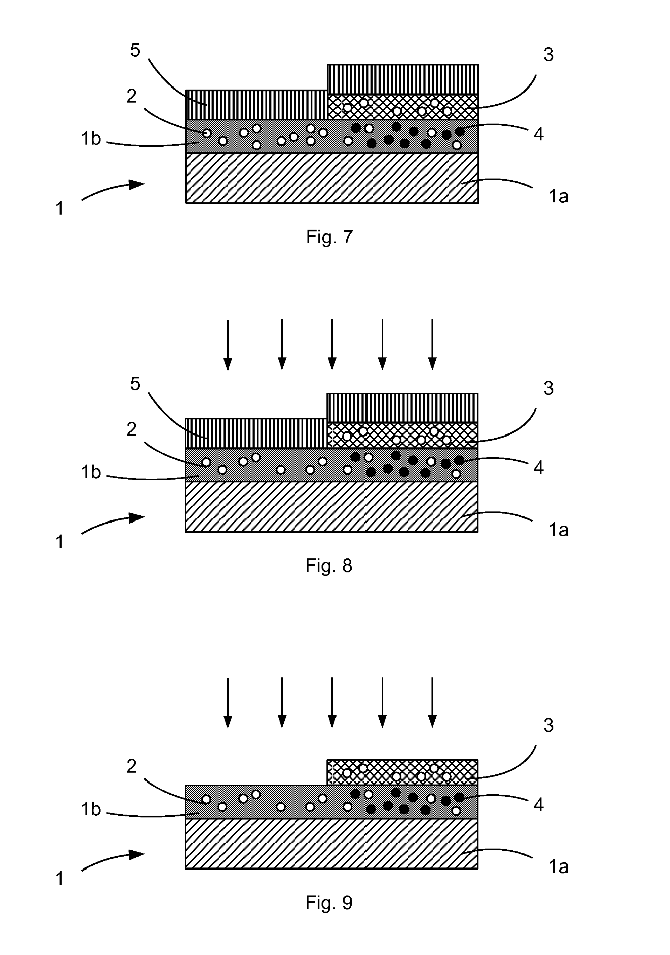

Par ailleurs, le traitement thermique permet d'activer les impuretés dopantes 2 et les impuretés dopantes supplémentaires 4. Sachant que le rayon atomique des atomes de silicium est de 1.17 Å, que celui des atomes de gallium est de 1.26 Å, et que celui des atomes de magnésium est de 1.36 Å, il est avancé que les atomes de silicium se placent plus facilement en position substitutionnelle dans la couche en matériau semi-conducteur 1b que les atomes de magnésium. Par conséquent, le taux d'activation des impuretés de type Si est plus élevé que le taux d'activation des impuretés de type Mg dans la zone recouverte par le masque 3 (cf. figure 7).

Les inventeurs ont observé que le taux d'activation des dopants de type n (impuretés de type Si) peut atteindre 100%, tandis que le taux d'activation des dopants de type p (impuretés de type Mg) est compris entre 5 à 30%.

Suite au traitement thermique, le masque 3 et la couche de protection 5 peuvent être retirés (cf. figures 8 et 9). On peut par exemple réaliser une gravure humide à l'aide d'acide phosphorique pour la couche de protection si cette dernière est en AIN ou SiNₓ, et à l'aide d'acide fluorhydrique pour enlever le masque 3 s'il est en SiOₓ ou SiNₓ. De manière alternative, la couche de protection 5 peut être retirée par planarisation mécano-chimique (« Chemical-Mechanical Planarization » ou « CMP » en anglais), ou toute autre technique de gravure adaptée.

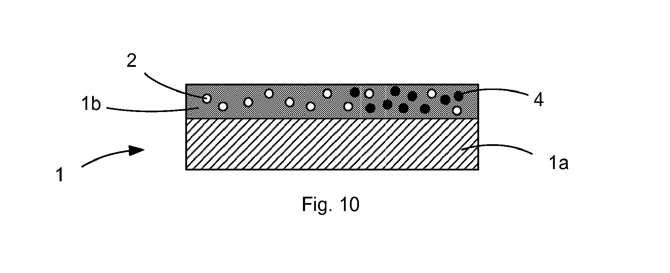

La mise en oeuvre du procédé permet donc de réaliser un substrat 1 comportant une couche semi-conductrice 1 b dopée p dans certaines zones et dopée n dans d'autres zones (cf. figure 10). Ce procédé peut donc être utilisé dans la fabrication de dispositifs nécessitant des jonctions p-n, telles que les diodes Schottchy, dans les transistors à effet de champ (« Metal semi-conductor Field Transistor » ou « MESFET » en anglais), ou les transistors à haute mobilité électronique (« High Electron Mobility Transistor » ou « HEMT » en anglais).

Selon un mode de mise en oeuvre alternatif non représenté, il est envisageable de retirer le masque 3 avant de déposer la couche de protection 5, avant de réaliser l'étape de traitement thermique. Toutefois cela limite la concentration en dopants de type n dans la couche en matériau semi-conducteur 1b, puisqu'une quantité importante d'ions Si⁺ diffusent au cours du traitement thermique.

Selon un troisième mode de mise en oeuvre du procédé, il peut être envisagé de déposer tout d'abord une couche de protection 5 ne recouvrant que certaines zones du substrat 1. On peut ensuite déposer le masque 3 sur d'autres zones du substrat recouvrant ou non la couche de protection 5. Les épaisseurs de la couche de protection 5 et du masque 3 sont judicieusement choisies de sorte à correctement protéger le substrat 1. Ainsi, lorsque l'étape d'implantation est réalisée, on assiste à :
- une implantation d'impuretés dopantes 2 dans les zones découvertes du substrat 1,
- une implantation d'impuretés dopantes 2 et d'impuretés dopantes supplémentaires 4 dans les zones du substrat 1 uniquement recouvertes par le masque 3,
- aucune implantation dans les zones du substrat 1 recouvertes par la couche de protection 5.

Ce mode de mise en oeuvre du procédé permet avantageusement de réaliser des jonctions p-i-n de manière simple et efficace.

Enfin, dans un quatrième mode de mise en oeuvre, il est possible de réaliser l'étape de traitement thermique sans avoir déposé de couche de protection 5 au préalable. Cela est envisageable si le traitement thermique est réalisé au moyen de recuits standards réalisés à des températures inférieures à 1000°C, c'est-à-dire des températures où la dégradation du substrat 1 est faible. Si le traitement thermique est réalisé au moyen de recuits rapides, il est possible de monter à une température de l'ordre de 1100°C pendant quelques secondes.

Pour former une zone dopée p adjacente à une zone dopée n dans un semi-conducteur à base de GaN, différentes mises en oeuvre du procédé qui vient d'être décrit peuvent être envisagées.

La couche 1 b en matériau à base de GaN peut être initialement dopée p. Dans ce cas, les impuretés dopantes 2 peuvent être électriquement neutres ou être des dopants de type p. L'énergie d'implantation est choisie en fonction de l'épaisseur du masque 3, de sorte que la profondeur d'implantation moyenne des dopants soit localisée dans le masque 3. Le rôle des impuretés dopantes est alors simplement de pousser les atomes de Si du masque 3 dans la couche semi-conductrice 1 b. Les atomes de Si jouent le rôle d'impuretés dopantes supplémentaires 4. Dans les zones qui ne sont pas recouvertes par le masque 3, le type de conductivité n'est pas modifié par l'implantation. En revanche, dans les zones recouvertes par le masque 3, le type de conductivité du semi-conducteur 1 b après traitement thermique est avantageusement de type n, pour former une jonction p-n horizontale.

Si la couche semi-conductrice 1 b est initialement dopée p, les impuretés dopantes 2 peuvent également être des dopants de type n. Dans ce cas, le masque 3 recouvre avantageusement tout le substrat 1. Certaines zones du masque 3 ont un pouvoir d'arrêt plus important que d'autres zones adjacentes du masque 3. De cette façon, dans les zones où le pouvoir d'arrêt est élevé, les dopants ne parviennent pas à traverser le masque 3, et la couche semi-conductrice 1b reste dopée p. Dans les zones où le pouvoir d'arrêt du masque 3 est faible, les dopants parviennent à travers le masque 3, et la couche semi-conductrice 1 b peut être dopée n. Une manière d'adapter le pouvoir d'arrêt du masque dans certaines zones est de faire varier l'épaisseur du masque 3. Dans les zones où on souhaite avoir un dopage p, l'épaisseur du masque 3 est suffisamment importante pour arrêter les impuretés dopantes 2 et pousser les atomes de Si sur une épaisseur telle qu'ils sont arrêtés avant d'arriver à l'interface entre le masque 3 et la couche en matériau semi-conducteur 1 b. De cette façon, l'implantation des dopants de type n ne modifie pas le type de conductivité de la couche à base de GaN dans les zones où on souhaite un dopage de type p. Dans les zones où l'on souhaite avoir un dopage n, le masque 3 a une épaisseur plus faible, et l'énergie d'implantation est choisie de sorte à pousser des atomes de Si du masque 3 dans la couche en matériau semi-conducteur 1 b.

Si la couche en matériau semi-conducteur 1 b n'est pas dopée initialement, alors les impuretés dopantes 2 sont avantageusement des dopants de type p, par exemple des ions Mg⁺. Le substrat 1 n'est recouvert par le masque 3 que dans les zones où un dopage de type n est souhaité. Comme pour les autres modes de mise en oeuvre qui viennent d'être présentés, l'énergie d'implantation des impuretés dopantes est choisie en fonction de l'épaisseur du masque 3, de façon à ce que la profondeur moyenne d'implantation des impuretés dopantes 2 soit localisée dans le masque 3. Lors de l'implantation, les impuretés dopantes 2 poussent les atomes de Si du masque 3 dans la couche semi-conductrice 1b dans les zones recouvertes par le masque, tandis que dans les zones non recouvertes les dopants de type p sont implantés directement dans la couche semi-conductrice 1b. Le traitement thermique permet ensuite d'activer les dopants et de placer la zone n à une profondeur équivalente à celle de la zone p afin d'obtenir la jonction p-n horizontale.

Pour mieux contrôler la profondeur d'implantation des impuretés dopantes 2 et des impuretés dopantes supplémentaires 4 dans la couche en matériau semi-conducteur 1b, une couche de protection 5 peut être déposée avant l'implantation. Son épaisseur permet de contrôler localement le profil de concentration des dopants activés n et p, de sorte à obtenir une zone dopée n adjacente à une zone dopée p, c'est-à-dire une jonction p-n horizontale. Le matériau de la couche de protection 5 peut par exemple être en AIN.

Le tableau ci-dessous présente deux jeux de paramètres pour lesquels une jonction p-n horizontale peut être obtenue dans une couche semi-conductrice 1 b à base de GaN lorsque les dopants sont des atomes de Mg, et qu'une couche de protection 5 en AIN ou en AlGaN est déposée avant de réaliser l'étape d'implantation des impuretés dopantes 2.

| | Cas n°1 | Cas n°2 |
|---|---|---|
| Epaisseur du masque [nm] | 5-10 | 50-100 |
| Concentration des atomes de Si à la profondeur Rₚ [at/cm³] | 10²⁰-10²¹ | 5.10¹⁸-5.10¹⁹ |
| Epaisseur de la couche de protection [nm] | 30-150 | 150-250 |
| Profondeur de diffusion des atomes de Si dans le GaN [nm] | 30-150 | 150-250 |
| Profondeur d'implantation des atomes de Mg dans le GaN [nm] | 30-150 | 150-250 |
| Energie d'implantation des atomes de Mg [keV] | 30-100 | 100-250 |

Les épaisseurs du masque 3 et de la couche de protection 5 sont choisies en fonction de la profondeur d'implantation des atomes de Mg et de diffusion des atomes de Si dans la couche semi-conductrice 1 b. L'énergie d'implantation des atomes de Mg est déterminée de sorte que la profondeur d'implantation moyenne soit localisée dans le masque 3, à proximité de l'interface avec le substrat 1.

Bien entendu, ces jeux de paramètres ne sont pas exhaustifs. D'autres jeux de paramètres permettent d'obtenir un résultat équivalent, c'est-à-dire la création d'une zone dopée n adjacente à une zone dopée p.

## Revendications

1. Procédé de dopage d'un semi-conducteur à base de GaN pour fabriquer une jonction p-n, comportant les étapes suivantes :
• prévoir un substrat (1) comprenant une couche en matériau semi-conducteur (1b) à base de GaN recouvert par un masque (3) à base de silicium,
• implanter des impuretés dopantes (2) dans le masque (3) de manière à transférer des impuretés dopantes supplémentaires (4) de type Si par diffusion depuis le masque (3) vers la couche en matériau semi-conducteur (1b) pour former une zone de type n adjacente à une zone de type p,
• réaliser un traitement thermique configuré pour activer les impuretés dopantes (2) et les impuretés dopantes supplémentaires (4).

2. Procédé de dopage d'un semi-conducteur selon la revendication 1, dans lequel le masque (3) couvre partiellement le substrat (1) de manière à définir une zone recouverte par le masque (3) et une zone découverte.

3. Procédé de dopage d'un semi-conducteur selon l'une quelconque des revendications 1 ou 2, dans lequel les impuretés dopantes (2) sont de type p.

4. Procédé de dopage d'un semi-conducteur selon l'une quelconque des revendications 1 à 3, dans lequel la profondeur d'implantation moyenne en impuretés dopantes (2) est disposée à une distance au moins égale à 300 nm de l'interface entre le masque (3) et la couche en matériau semi-conducteur, de sorte à incorporer des impuretés dopantes supplémentaires (4) dans la couche en matériau semi-conducteur (1 b).

5. Procédé de dopage d'un semi-conducteur selon l'une quelconque des revendications 1 à 4, comprenant une étape de dépôt d'une couche de protection (5) réalisée avant l'étape de traitement thermique.

6. Procédé de dopage d'un semi-conducteur selon la revendication 5, dans lequel l'étape de dépôt de la couche de protection (5) est réalisée avant l'étape d'implantation des impuretés dopantes (2).

7. Procédé de dopage d'un semi-conducteur selon la revendication 6, dans lequel le dépôt de la couche de protection (5) est réalisé après l'étape d'implantation des impuretés dopantes (2) et des impuretés dopantes supplémentaires (4).

8. Procédé de dopage d'un semi-conducteur selon l'une quelconque des revendications 5 à 7, dans lequel le matériau de la couche de protection (5) est choisi parmi l'oxyde d'aluminium, le nitrure d'aluminium, l'oxyde de silicium, ou le nitrure de silicium du type SiₓN_{y}, le silicium amorphe et les composés du type HfSiₓO_{y}.

9. Procédé de dopage d'un semi-conducteur selon l'une quelconque des revendications 5 à 8, comportant une étape de retrait de la couche de protection (5) par gravure après le traitement thermique.

10. Procédé de dopage d'un semi-conducteur selon l'une quelconque des revendications 1 à 9, dans lequel l'étape d'implantation est réalisée à une température comprise entre 15 et 700°C, de préférence entre 450 et 600°C.

11. Procédé de dopage d'un semi-conducteur selon l'une quelconque des revendications 1 à 10, dans lequel l'étape de traitement thermique est une combinaison d'au moins deux recuits de durées et de températures différentes.

12. Procédé de dopage d'un semi-conducteur selon la revendication 11, dans lequel au moins l'un des recuits est réalisé à une température supérieure à 1000°C.

13. Procédé de dopage d'un semi-conducteur selon l'une quelconque des revendications 1 à 12, dans lequel l'épaisseur du masque (3) est comprise entre 2 et 400 nm.

14. Procédé de dopage d'un semi-conducteur selon l'une quelconque des revendications 1 à 13, dans lequel l'épaisseur de la couche en matériau semi-conducteur (1 b) est comprise entre 5 nm et 10 µm, préférentiellement entre 500nm et 10*µ*m, idéalement égale à 1*µ*m.
